# DEMANDE DE BREVET EUROPEEN

(11) **EP 1 760 592 A2**
(43) Date de publication de la demande: **07.03.2007**
(21) Numéro de dépôt: 06119097.1
(22) Date de dépôt: 17.08.2006
(51) Int. Cl.: G06F 11/22

(54) **Système et procédé de test d'un module de commande relié à un bus LIN**

(30) Priorité: 02.09.2005 FR 0509006
(71) Demandeur: Valeo Systèmes Thermiques, 78321 Le Mesnil St Denis Cedex (FR)
(72) Inventeur: Moreau, Fabrice, 94000 Créteil (FR); Chemoul, Steeve, 94000 Créteil (FR)

(57) **Abrégé**

L'invention concerne un module de commande (MM) destiné à être connecté à un bus série de communication (LIN) selon le protocole LIN. Ce module de commande (MM) présente deux modes de fonctionnement, un mode de test dans lequel il active une unité de test (TPU) et un mode fonctionnel dans lequel il active une unité fonctionnelle (FMU). Le module de commande (MM) selon l'invention comporte une unité de détection (ADU) apte à détecter, à sa mise sous tension, sur le bus série de communication (LIN) auquel il est connecté, des signaux d'activité d'un module de test (MT) connecté au même bus série de communication (LIN) et à passer en mode de test en activant l'unité de test (TPU) lorsque de tels signaux d'activité sont détectés.

## Description

La présente invention se rapporte au domaine général des tests et diagnostics de modules de commande destinés à être connectés à un bus série de communication selon le protocole LIN.

Les bus série de communication sont communément utilisés pour les communications entre les différents éléments électroniques présents dans un véhicule. Ces éléments électroniques sont par exemple, des capteurs, des indicateurs et des actionneurs, ainsi mis en réseau par l'intermédiaire de tels bus série.

Dans les applications automobiles, les capteurs et actionneurs concernent, par exemple, le système d'air conditionné, les portes (ouverture...), les ceintures, les sièges, les mesures de température, les commandes manuelles, les essuie-glaces, les déclencheurs de toit ouvrant...

Parmi les bus série de communication, certains sont particulièrement adaptés à une application automobile. C'est le cas du bus selon le protocole LIN.

Le protocole LIN a été développé, notamment, afin de limiter le coût de l'installation d'un réseau entre les différents capteurs et actuateurs présents dans une voiture. En effet, les réseaux précédemment utilisés étaient réalisés avec des bus de communication coûteux et généralement sous-exploités.

Les bus de communication selon le protocole LIN présentent peu de compatibilité avec les autres protocoles connus de bus série mais présentent, en revanche, d'autres avantages pour les applications automobiles. Ainsi, les bus selon le protocole LIN fonctionnent sur 12 Volts ce qui les rend particulièrement adaptés aux applications automobiles dans lesquelles la batterie fonctionne précisément à ce voltage.

Dans les architectures conventionnelles, des modules de commande assurant l'interface avec les différents éléments électroniques du véhicule sont connectés au bus série de communication. Un module, dit maître, unique, gère les communications sur le bus de communication. Les autres modules connectés sont des modules esclaves.

Avant leur mise en fonctionnement ou après celle-ci, il est avantageux de pouvoir vérifier que les modules de commande ont un fonctionnement correct. Les modules susceptibles d'être testés présentent deux modes de fonctionnement :
- un mode de test dans lequel il active une unité de test;
- un mode fonctionnel dans lequel il active une unité fonctionnelle.

Il est alors possible de tester les modules de commande en utilisant une liaison spécifique connectée à un module de test.

Cette solution présente toutefois l'inconvénient de devoir ajouter, dans chaque module susceptible d'être testé, des ressources matérielles supplémentaires pour assurer la connexion avec la liaison spécifique dont le coût se reporte sur le prix de l'installation d'un réseau entre les différents éléments électroniques du véhicule.

La présente invention a donc pour but principal de pallier de tels inconvénients en proposant un module de commande destiné à être connecté à un bus série de communication selon le protocole LIN, comportant une unité de détection apte à détecter, à sa mise sous tension, sur le bus série de communication auquel il est connecté, des signaux d'activité d'un module de test connecté au même bus série de communication et à passer en mode de test en activant l'unité de test lorsque de tels signaux d'activité sont détectés.

Avec un tel module de commande, il est alors inutile de prévoir une liaison spécifique puisque la connexion sur le bus de communication est suffisante. En effet, c'est grâce à une information circulant sur le bus LIN que le module de commande passe de lui-même en mode de test. En outre, ce mode de test permet au module de commande d'échanger les données de test directement sur le bus LIN.

Selon une autre caractéristique particulière de l'invention, le module de commande est en outre adapté à envoyer des signaux d'indication de son passage en mode de test sur le bus série de communication.

L'invention concerne également un module de test destiné à tester au moins un module de commande destiné à être connecté à un bus série de communication selon le protocole LIN, caractérisé en ce que, lorsqu'il est connecté au bus série de communication selon ledit protocole LIN, il est adapté, à sa mise sous tension, à émettre les signaux d'activité sur le bus série de communication.

Selon une caractéristique particulière de l'invention, les signaux d'activité sont constitués par des motifs périodiques.

Selon une autre caractéristique particulière de l'invention, le module de test est adapté à détecter des signaux d'indication de passage en mode de test dudit module de commande sur le bus série de communication et à déclencher un échange de données de test lorsqu'une telle détection a lieu.

L'invention concerne aussi un système de test comprenant un module de test pour tester au moins un module de commande, chacun étant destiné à être connecté à un bus série de communication selon le protocole LIN et caractérisé en ce que le module de test est adapté à émettre, une fois connecté au bus série de communication et mis sous tension, des signaux d'activité sur le bus série de communication.

L'invention concerne enfin un procédé de test d'un module de commande destiné à être connecté à un bus série de communication selon le protocole LIN et présentant deux modes de fonctionnement, un mode de test et un mode fonctionnel, le procédé étant caractérisé en ce qu'il comprend les étapes suivantes :
- connexion du module de test sur le bus série de communication selon le protocole LIN,
- mise sous tension du module de test,
- envoi, par le module de test, de signaux d'activité sur le bus,
- mise sous tension du module de commande à tester,
- détection, par le module de commande, des signaux d'activité,
- activation de l'unité de test du module de commande, et
- échange de données de test entre le module de commande à tester et le module de test.

Selon une caractéristique particulière de l'invention, le procédé de test comprend en outre, après l'étape de passage en mode de test du module de commande et avant l'étape d'échange de données de test, les étapes suivantes :
- envoi, par le module de commande, de signaux d'indication de passage en mode de test sur le bus série de communication,
- détection, par le module de test, des signaux d'indication de passage en mode de test, ladite détection déclenchant l'échange de données de test.

D'autres caractéristiques et avantages de la présente invention ressortiront de la description faite ci-dessous, en référence aux dessins annexés qui en illustrent un exemple de réalisation dépourvu de tout caractère limitatif, sur lesquels :
- la figure 1 est une représentation schématique de la mise en oeuvre d'un test pour des modules de commande selon l'art antérieur ;
- la figure 2 est une représentation schématique du format des messages tels qu'échangés en mode fonctionnel sur le bus de communication ;
- la figure 3 est une représentation schématique de la mise en oeuvre d'un test pour des modules de commande selon l'invention ; et
- la figure 4 présente les différents états du bus de communication selon une mise en oeuvre particulière de l'invention.

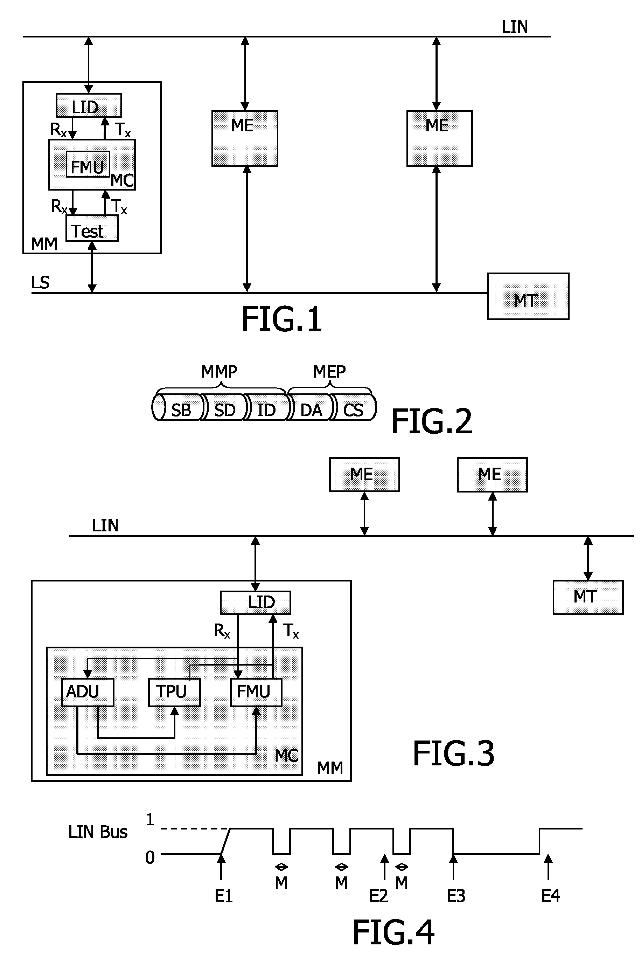

La figure 1 décrit la mise en oeuvre d'un test selon l'art antérieur. Cette mise en oeuvre utilise une liaison spécifique LS reliée à un module de test MT. La liaison spécifique est également reliée aux divers modules de commande susceptibles d'être testés. Il s'agit de modules esclaves ME et d'au moins un module maître MM également relié à un bus de communication LIN.

Ainsi que représenté uniquement pour le module maître MM, ces modules de commande incluent classiquement un microcontrôleur MC comprenant une unité fonctionnelle FMU dialoguant en réception Rx et en transmission Tx avec d'une part une interface de contrôle LID du bus série de communication LIN et d'autre part une interface de test avec la liaison spécifique LS. Les modules esclaves possèdent, comme le module MM, une unité fonctionnelle, bien sûr différente de celle du module MM, et une interface avec le bus LIN, non représentées.

La figure 2 représente schématiquement la structure d'un message selon le protocole à maître unique LIN. Dans ce message, une première partie dite d'identification MMP est émise par le module maître sur le bus, la seconde partie dite de réponse MEP est émise par le module esclave dont une réponse est requise dans la partie d'identification MMP. Le module esclave concerné par la partie d'identification MMP peut aussi ne pas répondre.

Typiquement, la partie d'identification MMP comprend un signal de synchronisation SB (« Sync Break » en anglais), des données de synchronisation SD (« Sync Byte » en anglais) qui donne une base de temps pour la synchronisation des modules esclaves ME, un champ d'identification ID incluant un identifiant du message et deux bits de parité. L'identifiant du message comprend des informations sur l'émetteur du message, le destinataire, le but et la longueur du champ de données.

La partie de réponse MEP comprend des données DA et des bits de vérification CS (« Check Sum » en anglais).

La figure 3 représente un exemple de mise en oeuvre d'un test selon l'invention. Sur cette figure, l'invention est décrite en référence à un module maître MM. Mais, bien entendu elle trouve application également au niveau des modules esclaves ME.

Selon le mode de réalisation présenté sur la figure 3, un module maître MM, des modules esclaves ME et un module de test MT sont connectés à un bus de communication selon le protocole LIN.

Le module de test MT et le bus de communication LIN définissent un système de test au sens de l'invention. Le protocole LIN permet de réaliser des réseaux peu coûteux entre modules de commande associés à des éléments électroniques du véhicule.

L'invention permet de réaliser des tests sur les modules de commande de manière très peu coûteuse et simple à mettre en oeuvre.

Selon l'invention, le module de commande maître MM présente un microcontrôleur MC qui inclut une unité de détection d'activité ADU. A la mise sous tension du module de commande, cette unité de détection ADU lit le signal Rx et détecte si une activité est présente ou non sur le bus de communication LIN. Afin de pouvoir utiliser des signaux d'activité du module de test s'étalant dans le temps, il est nécessaire que la lecture du signal Rx se fasse sur un laps de temps prédéfini dans le module de commande MM.

Il est donc avantageux d'utiliser des signaux d'activité périodiques dont la période est choisie sur un intervalle donné de durées. Cela permet d'intégrer la durée maximale de la période du signal périodique en tant que laps de temps prédéfini dans les modules de commande.

On note aussi que les signaux d'activité ne possèdent pas la structure des messages tels que définis par le protocole LIN afin d'éviter qu'ils ne soient confondus avec des messages provenant d'autres modules de commande éventuellement connectés et mis sous tension sur le bus LIN.

Si le module de test MT est mis sous tension, des signaux d'activité du module de test sont alors détectés par le module de commande MM sur le signal Rx, le microcontrôleur MC entre alors en mode de test en activant une unité de test TPU. Ainsi, à partir du moment où un module de test MT est connecté à un module de commande MM ou ME par un bus de communication série LIN, le protocole LIN n'est plus respecté.

Si le module de test MT n'est pas sous tension ou qu'il n'y a pas de module de test au sens de l'invention connecté au bus de communication et mis sous tension, aucun signal d'activité n'est détecté pendant le laps de temps prédéfini, le module de commande entre alors en mode fonctionnel en activant une unité fonctionnelle FMU. En effet, si le module maître MM est connecté à un ou plusieurs modules esclave ME par un bus de communication série LIN (configuration fonctionnelle), le protocole LIN est respecté. Ceci est une exigence fonctionnelle du système.

Dans l'exemple de la figure 3, cette unité fonctionnelle FMU est telle que le module de commande MM gère le bus série de communication en tant que maître sur le bus.

La figure 4 illustre l'état du bus durant un exemple de mise en oeuvre de l'invention. Elle présente aussi un exemple de signaux d'activité au sens de l'invention. Hors tension, un module de test est connecté à une ligne du bus de communication LIN dont on souhaite tester les modules de commande qui y sont connectés. A l'instant E1, le module de test MT est mis sous tension. Il émet alors continûment un motif M qui constitue des signaux d'activité. Par exemple, comme représenté sur la figure 4, une mise à zéro pendant un temps spécifié puis une mise à 1 de l'état du bus. Le motif M est émis et répété par le module de test MT. La durée qui s'écoule ou périodicité entre deux répétitions de la même chaîne de motifs peut être peu précise, l'important étant que la répétition du motif le soit.

Il importe que le même message soit répété et que l'intervalle de temps entre deux émissions n'excède pas une durée limite. Au-delà de cette durée, le module considère que la trame n'est pas conforme au format du protocole LIN et par conséquent, se met dans une nouvelle phase d'attente d'un nouveau message.

Le module de commande MM est ensuite mis sous tension à un instant E2. Il lit alors le signal Rx pendant un laps de temps prédéfini et détecte alors le motif M sur la ligne du bus de communication LIN. Le module de commande MM passe alors en mode de test à l'instant E3 et force alors le bus à 0 pendant un temps spécifié pour indiquer son passage en mode de test. Cela constitue un exemple de signaux d'indication.

L'utilisation de tels signaux d'indication de passage en mode de test en provenance du module de commande MM permet de déclencher l'envoi de données de test par le module de test MT directement et simplement en utilisant le bus de communication LIN à l'exclusion de tout autre élément additionnel.

Ainsi, à l'instant E4, le module de test MT commence les échanges de données du mode de test.

Selon l'invention, on utilise le bus LIN pour ses caractéristiques de liaison série. On note que les données de test peuvent ou non présenter la structure de messages propre au protocole LIN. Dans le cas où des messages selon le protocole LIN servent à l'échange de données de test, le module de test se comporte préférentiellement en module maître, quel que soit le module de commande testé, maître ou esclave.

On note qu'à la suite d'un test, pour que le module de commande MM passe de nouveau en mode fonctionnel, il suffit de le mettre hors tension puis de le connecter avec un bus de communication sur lequel aucun module de test MT au sens de l'invention est connecté et mis sous tension. Cette dernière situation peut correspondre à diverses mises en oeuvre : on peut juste mettre hors tension le module de test MT connecté au bus de communication ou le déconnecter, on peut également déconnecter le module de commande du bus de communication sur lequel s'est déroulé le test et le rebrancher sur un autre bus n'étant connecté à aucun module de test sous tension. Les tests peuvent également se faire sur des modules esclaves ME.

La présente invention trouve une application toute particulière dans le test de modules de commande. Ce test peut être réalisé module par module de façon unitaire afin de vérifier leur bon fonctionnement. Il est alors réalisé sur chaîne de montage ou en laboratoire préalablement à l'installation et à sa connexion sur le bus série de communication reliant les divers éléments électroniques d'une installation.

On remarque enfin que des mises en oeuvre diverses peuvent être réalisées selon les principes de l'invention. Notamment, on souligne ici que l'invention peut être mise en oeuvre dans tous les modules de commande, indifféremment maître ou esclave, susceptibles de subir un test.

## Revendications

1. Module de commande (MM) destiné à être connecté à un bus série de communication selon le protocole LIN, présentant deux modes de fonctionnement :
- un mode de test dans lequel il active une unité de test (TPU) et,
- un mode fonctionnel dans lequel il active une unité fonctionnelle (FMU),
**caractérisé en ce qu'**il comporte une unité de détection (ADU) apte à détecter, à sa mise sous tension, sur le bus série de communication auquel il est connecté, des signaux d'activité d'un module de test (MT) connecté au même bus série de communication et à passer en mode de test en activant l'unité de test (TPU) lorsque de tels signaux d'activité sont détectés.

2. Module de commande (MM) selon la revendication 1, **caractérisé en ce qu'**il est en outre adapté à envoyer des signaux d'indication de son passage en mode de test sur le bus série de communication.

3. Module de test (MT) destiné à tester au moins un module de commande (MM) selon la revendication 1 ou 2, **caractérisé en ce que**, lorsqu'il est connecté au bus série de communication selon ledit protocole LIN, il est adapté, à sa mise sous tension, à émettre des signaux d'activité sur le bus série de communication.

4. Module de test (MT) selon la revendication 3, **caractérisé en ce que** les signaux d'activité sont constitués par des motifs (M) périodiques.

5. Module de test (MT) selon la revendication 3 ou 4, **caractérisé en ce qu'**il est adapté à détecter les signaux d'indication de passage en mode de test dudit module de commande (MM) sur le bus série de communication et à déclencher un échange de données de test lorsqu'une telle détection a lieu.

6. Système de test comprenant un module de test (MT) pour tester au moins un module de commande (MM) selon la revendication 1 ou 2, **caractérisé en ce que** le module de test (MT) et au moins un module de commande sont connectés au bus série de communication selon ledit protocole LIN, le module de test (MT) étant adapté à émettre, une fois connecté au bus série de communication et mis sous tension, des signaux d'activité sur le bus série de communication.

7. Procédé de test d'un module de commande (MM) selon la revendication 1 ou 2, le procédé étant **caractérisé en ce qu'**il comprend les étapes suivantes :
- connexion d'un module de test (MT) sur le bus série de communication selon le protocole LIN,
- mise sous tension du module de test (MT),
- envoi, par le module de test (MT), de signaux d'activité sur le bus série de communication,
- mise sous tension du module de commande (MM) à tester,
- détection, par le module de commande (MM), des signaux d'activité,
- activation de l'unité de test (TPU) du module de commande (MM),
- échange de données de test entre le module de commande (MM) à tester et le module de test (MT).

8. Procédé de test selon la revendication 7, **caractérisé en ce qu'**il comprend en outre, après l'étape de passage en mode de test du module de commande (MM) et avant l'étape d'échange de données de test, les étapes suivantes :
- envoi, par le module de commande (MM), de signaux d'indication de passage en mode de test sur le bus série de communication,
- détection, par le module de test (MT), des signaux d'indication de passage en mode de test, ladite détection déclenchant l'échange de données de test.
